(19)

Europäisches Patentamt
European Patent Office
Office européen des brevets

(11) **EP 2 389 728 B1**

(12) **EUROPÄISCHE PATENTSCHRIFT**

(45) Veröffentlichungstag und Bekanntmachung des Hinweises auf die Patenterteilung:
**26.02.2020 Patentblatt 2020/09**

(21) Anmeldenummer: **10716750.4**

(22) Anmeldetag: **21.01.2010**

(51) Int Cl.:
*H03K 17/975* (2006.01)     *H03K 17/96* (2006.01)
*G06F 3/041* (2006.01)     *G06F 3/044* (2006.01)

(86) Internationale Anmeldenummer:
**PCT/EP2010/000350**

(87) Internationale Veröffentlichungsnummer:
**WO 2010/084004 (29.07.2010 Gazette 2010/30)**

(54) **SYSTEM ZUR DETEKTION DER BERÜHRUNG EINES DISPLAYS**

SYSTEM FOR DETECTING THE CONTACT WITH A DISPLAY

SYSTÈME PERMETTANT DE DÉTECTER LE CONTACT D'UN ÉCRAN D'AFFICHAGE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **21.01.2009 DE 102009005567
22.01.2009 DE 102009005611**

(43) Veröffentlichungstag der Anmeldung:
**30.11.2011 Patentblatt 2011/48**

(73) Patentinhaber: **Microchip Technology Germany GmbH
82205 Gilching (DE)**

(72) Erfinder: **FASSHAUER, Peter
85579 Neubiberg (DE)**

(74) Vertreter: **sgb europe
Lechnerstraße 25a
82067 Ebenhausen (DE)**

(56) Entgegenhaltungen:
**WO-A1-2007/048640     WO-A2-2007/022259
DE-A1-102006 051 184     GB-A- 2 394 775**

**Beschreibung**

Die vorliegende Erfindung betrifft ein System durch welches eine leichte Berührung eines Bildschirms, Displays oder anderweitigen Scheibenelementes durch einen Finger oder Stift erkannt werden kann, um hierdurch weitere Funktionen, wie z.B. eine Initialisierung für eine Cursorsteuerung zu aktivieren.

Aus der internationalen Anmeldungsveröffentlichung WO 2007/022259 ist eine berührungskontrollierte Anzeigevorrichtung bekannt.

Der Erfindung liegt die Aufgabe zugrunde, die Erfassung der Berührung vorgenannter Strukturen in einer gegenüber bisherigen Lösungsansätzen verbesserten Weise zu ermöglichen.

Diese Aufgabe wird mit den kennzeichnenden Merkmalen des Patentanspruchs 1 gelöst.

Dadurch wird es auf vorteilhafte Weise möglich, über eine Belastung der Lagerstruktur und die damit einhergehende geringfügige Positionsänderung der Scheibenstruktur eine Berührung derselben zu erfassen und anhand des entsprechenden Detektionsereignisses weitere Schaltungsvorgänge, beispielsweise einen Wakeup Modus eines elektronischen Gerätes einzuleiten. Das erfindungsgemäße Lösungskonzept eignet sich insbesondere zur Anwendung bei Mobiltelefonen, PDA 's, mobilen Eingabegeräten, Fernsteuerungen und insbesondere auch Spielcomputern.

Vorzugsweise ist der Scheibenkorpus als Rechteckscheibe ausgeführt. Die Elektrodenabschnitte befinden sich hierbei vorzugsweise im Eckbereich des Scheibenkorpus. Die Elektrodenabschnitte sind vorzugsweise als Flachelektroden, beispielsweise durch eine metallische Beschichtung realisiert.

Kurzbeschreibung der Figuren

Weitere Einzelheiten und Merkmale der Erfindung ergeben sich aus der nachfolgenden Beschreibung in Verbindung mit der Zeichnung. Es zeigt:

**Fig. 1a** eine erste Skizze zur Veranschaulichung des Aufbaus eines erfindungsgemäß ausgestatteten Displays;

**Fig. 1b** eine Schnittdarstellung zur weiteren Veranschaulichung des Aufbaus des Displays nach Figur 1a;

**Fig. 2a** eine Schaltungsskizze zur Veranschaulichung des Aufbaus einer ersten Schaltungsvariante zur Generierung eines Detektionssignales;

**Fig. 2b** eine Schaltungsskizze zur Veranschaulichung des Aufbaus einer zweiten Schaltungsvariante zur Generierung eines Detektionssignales;

Ausführliche Beschreibung der Erfindung in Verbindung mit den Figuren

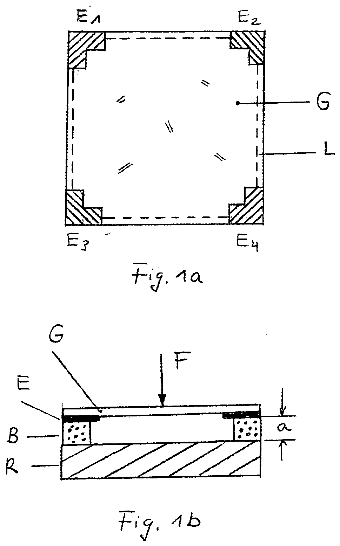

Das erfindungsgemäße Konzept zur Erfassung der Berührung eines Displays basiert auf einer kapazitiven Technologie, die nachstehend genauer beschrieben wird. Der Grundgedanke hierbei besteht darin, eine leichte Berührung der Scheibe des Displays über eine Kapazitätsänderung zu detektieren, indem entsprechend Fig.1a auf der Glasscheibe G streifenförmige Elektroden E1 bis E4 angebracht sind, die entweder ganz oder teilweise z.B. in vier Ecken oberhalb oder unterhalb der Scheibe liegen und mittels dünner Leiterbahnen verbunden werden, sodass eine einzige den Rand der Glasscheibe umspannende Elektrode entsteht.

Dieses Elektrodensystem kann auch durch Aufbringen einer leitfähigen Struktur auf der Scheibe realisiert werden. Die Ausgestaltung der Elektroden entsprechend Fig. 1a hat den Vorteil, dass nur ein geringer Teil der Glasfläche mit Elektrodenmaterial belegt wird und dadurch der übrige Teil des Glasrandes für andere Systeme wie z.B. Piezosensoren zur Positionserkennung eines Fingers genutzt werden kann.

Die Elektroden bilden gegenüber dem unter der Glasscheibe sitzenden Metallrahmen R eine Kapazität C, die sowohl durch die gesamte Fläche A der Elektroden als auch durch den Abstand a gemäß

$$C = \varepsilon \, A \, / \, a \qquad (1)$$

gegeben ist. Wird, wie in Fig. 1b dargestellt, die Glasscheibe einschließlich der aufgebrachten Elektrodenstreifen durch eine federnd auf dem Metallrahmen R ruhende Auflage B gelagert, so ergibt sich bei Berührung mit einer Kraft F eine Abstandsänderung $\Delta a$ und damit aus G1.1 eine relative Kapazitätsänderung

$$\Delta C/C \;=\; - \, \Delta a/a \qquad (2)$$

Die Ausgestaltung der Auflage B kann dabei in unterschiedlicher Weise, z.B. durch Metall- oder Kunststofffedern, Gummiprofile verschiedener Form oder auch Streifen aus Schaumstoffen erfolgen. Von besonderem Vorteil ist hierbei wenn das Material im elastischen (Hookschen) Bereich arbeitet, der durch eine Federkonstante k definiert werden kann, sodass bei einer Krafteinwirkung F die relative Kapazitätsänderung mittels G1.2 angegeben werden kann zu

$$\Delta C/C = F/ka \qquad (3)$$

Die Auswertung der Kapazitätsänderung $\Delta C$ und damit einer Berührung des Displayglases erfolgt im vorliegenden Fall mittels eines selektiven Kapazitätssensors insbesondere gemäß dem in PCT/EP2006/01043 beschriebenen Phasenverfahren, vorzugsweise in einer speziellen nachfolgend näher beschriebenen Variante bewerkstelligt werden.

Der erfindungsgemäße selektive Sensor ist von besonderem Vorteil, weil z.B. im Anwendungsfall eines Displays von der Elektronik des Gerätes erhebliche Störsignale von mehreren Volt Amplitude auf die Elektroden eingekoppelt werden, die auf den Sensoreingang wirken und ohne eine ausreichende Filterung bereits am Eingang eine zuverlässige Messung der Kapazitätsänderung und damit eine Detektion der Berührung verhindern würden. Für diese Sensorik wird erfindungsgemäß eine Schaltungsanordnung nach dem erwähnten und in PCT/EP2006/01043 beschriebenen Phasenverfahren verwendet, bei dem die hierzu erforderliche Induktivität durch eine aktive Anordnung ersetzt wird, wodurch die Verwendung einer Spule mit großer Induktivität vermieden wird und dadurch der Sensor platzsparend in die im Display vorhandene Elektronik integriert werden kann. Weiterhin besteht auch die Möglichkeit einer späteren Integration in einem ASIC.

Eine aktive Anordnung mit der Funktion einer Induktivität wird als Gyrator bezeichnet. Durch das dargestellte Netzwerk ergibt sich ein Minimum an elektronischen Bauteilen für die Erzeugung großer Induktivitäten mit hohem Gütefaktor Q. Die dargestellte Schaltungsanordnung umfasst einen Operationsverstärker als Impedanzwandler. Hierbei ergeben sich im Allgemeinen Spulen mit relativ geringer Güte Q. Für eine hohe Berührungsempfindlichkeit und damit hohe Messgenauigkeit von Kapazitätsänderungen werden vorzugsweise größere Gütefaktoren für das gewählte Phasenverfahren gewählt. Wie in PCT/EP2006/01043 dargestellt, ist die sich ergebende Phasenänderung $\Delta\Phi$(=Sensorempfindlichkeit) in der Umgebung der Resonanzfrequenz bestimmt durch

$$. \ \Delta\Phi = Q \ \Delta C/C \qquad (4)$$

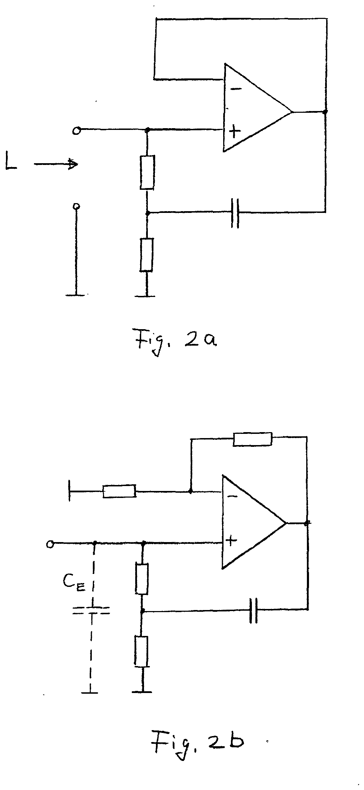

Je größer der Gütefaktor Q ist, umso geringere Kapazitätsänderungen $\Delta C$ können demnach ausgewertet werden. Dies wird erfindungsgemäß durch eine Modifikation der Schaltungsanordnung von Fig.2a erreicht, indem im Rückkopplungszweig des OPV der für eine Verstärkung >1 übliche Spannungsteiler gemäß Fig. 2b in das Netzwerk eingefügt wird und dadurch auf den positiven Signaleingang des OPV eine größere Spannung rückgekoppelt wird, wodurch der Gütefaktor der erzeugten Induktivität erheblich steigt. Die Ursache hierfür liegt darin, dass bei einer Verstärkung des OPV größer als 1 der Realteil der komplexen Eingangsimpedanz geringer wird, was einer Verringerung der Verluste und damit einer Vergrößerung der Güte entspricht.

Die genaue Dimensionierung des Spannungsteilers und damit der eingestellten Verstärkung hängt jeweils entscheidend vom Typ des gewählten Operationsverstärkers ab. Am Eingang der Anordnung von Fig.2b wird die dort wirksame Induktivität durch die Kapazität $C_E$ der angeschlossenen Elektrode zu einem selektiv wirkenden Parallelschwingkreis ergänzt und ergibt damit das für die Anwendung des Phasenverfahrens erforderliche Element.

Fasst man G1.3 und G1.4 zusammen, so erhält man schließlich den Zusammenhang zwischen der entstehenden Phasenverschiebung und der auf die Glasscheibe einwirkenden Kraft F zu

$$\Delta\Phi = QF/ka \qquad (5)$$

G1.5 beschreibt damit die Charakteristik eines Kraftsensors. In Verbindung mit der in der DE 10 2006 051 184.0 beschriebenen Umwandlung einer Phasenverschiebung in eine proportionale Änderung der Ausgangsspannung u des Sensors ergeben sich typischerweise Empfindlichkeiten $\Delta u/F$ von einigen mV/g. Dies ist ausreichend, um bei leichtem Fingerdruck auf die Glasplatte eine sichere Detektion trotz großer Störsignale durch die Elektronik des Displays zu gewährleisten.

Als Vorteile des erfindungsgemäßen Systems im Hinblick auf die vorliegende Applikation seien zusammenfassend genannt:

1. Einfache Detektion einer Berührung durch leichte Distanzänderung einer auf federndem Material gelagerten Glasscheibe, ohne dass größere Veränderungen der Konstruktion des Displays erforderlich sind .

2. Erweiterung einer im Display vorhandenen Funktionalität zur Positionserkennung mittels Piezosensoren.

3. Selektiver kapazitiver Sensor nach dem Phasenverfahren unter Verwendung einer modifizierten Gyratorschaltung, mit der eine hohe Berührungsempfindlichkeit bei großer Störunterdrückung erreicht wird.

**Patentansprüche**

1. Anordnung zur Detektion der Berührung eines Displays, mit:

   - einem Scheibenkorpus (G),
   - einer Elektrodeneinrichtung (E) die wenigstens einen Elektrodenabschnitt umfasst,
   - einer Lagerungsstruktur (B) zur Lagerung des Scheibenkorpus (G) derart, dass dieser infolge einer bei Berührung des Scheibenkorpus (G) ausgeübten Druckkraft eine hinreichende Verlagerung erfährt,
- einem Kapazitätssensor,
- wobei der wenigstens eine Elektrodenabschnitt mit dem Scheibenkorpus (G) gekoppelt ist, und der wenigstens eine Elektrodenabschnitt Teil eines kapazitiven Systems bildet dessen Kapazität sich bei Belastung der Lagerungsstruktur (B) verändert, **dadurch gekennzeichnet,**
- **dass** der wenigstens eine Elektrodenabschnitt als leitfähige Struktur direkt auf einer Unterseite des Scheibenkorpus (G) aufgebracht ist, und dass die Lagerungsstruktur (B) auf einem unter dem Scheibenkorpus angeordneten Metallrahmen (R) angeordnet ist so dass jeder Elektrodenabschnitt (E) in Kombination mit dem Metallrahmen (R) und der Lagerungsstruktur (B) einen variablen Kondensator formt welcher mit dem Kapazitätssensor koppelbar ist und der Kapazitätssensor derart ausgebildet ist, dass
- eine Änderung der Kapazität des kapazitiven Systems anhand eines Phasenverschiebungseffektes detektiert wird, und
- die Elektrodeneinrichtung einen Teil eines LC-Netzwerkes bildet und die Induktivität desselben durch eine Gyratorschaltung gebildet wird.

2. Anordnung nach Anspruch 1, **dadurch gekennzeichnet, dass** der Scheibenkorpus (G) als Rechteckscheibe ausgeführt ist, und dass sich der wenigstens eine Elektrodenabschnitt (E) im Eckbereich des Scheibenkorpus (G) befindet.

3. Anordnung nach Anspruch 2, **dadurch gekennzeichnet, dass** der wenigstens eine Elektrodenabschnitt als Flachelektrode ausgeführt ist.

4. Anordnung nach Anspruch 3, **dadurch gekennzeichnet, dass** die Flachelektrode als metallische Schicht ausgeführt ist.

5. Anordnung nach wenigstens einem der Ansprüche 1 bis 4, **dadurch gekennzeichnet, dass** der Scheibenkorpus (G) eine Glasscheibe umfasst.

6. Anordnung nach wenigstens einem der Ansprüche 1 bis 5, **dadurch gekennzeichnet, dass** der Kapazitätssensor einen als Impedanzwandler geschalteten Operationsverstärker umfasst.

7. Anordnung nach Anspruch 6, **dadurch gekennzeichnet, dass** der Operationsverstärker derart konfiguriert ist, dass eine Verstärkung > 1 vorliegt.

8. Anordnung nach wenigstens einem der Ansprüche 1 bis 7, wobei zur Positionserkennung eines Fingers auf dem Scheibenkörper Piezosensoren vorgesehen sind.

9. Anordnung nach wenigstens einem der Ansprüche 1 bis 8, **dadurch gekennzeichnet dass** die Lagerungsstruktur (B) durch Kunststofffedern gebildet wird.

10. Anordnung nach wenigstens einem der Ansprüche 1 bis 8, **dadurch gekennzeichnet dass** die Lagerungsstruktur (B) Metallfedern aufweist.

11. Anordnung nach wenigstens einem der Ansprüche 1 bis 8, **dadurch gekennzeichnet dass** die Lagerungsstruktur (B) ein Gummiprofil aufweist.

12. Anordnung nach wenigstens einem der Ansprüche 1 bis 8, **dadurch gekennzeichnet dass** die Lagerungsstruktur (B) Streifen aus Schaumstoff aufweist.

13. Anordnung nach wenigstens einem der Ansprüche 11 bis 12, **dadurch gekennzeichnet dass** ein Material der Lagerungsstruktur (B) im elastischen (Hookschen) Bereich arbeitet, der durch eine Federkonstante k definiert werden kann.

14. Anordnung nach wenigstens einem der Ansprüche 1 bis 10, **dadurch gekennzeichnet dass** die Lagerungsstruktur (B) Streifen aus Schaumstoff aufweist.

15. Anordnung nach wenigstens einem der Ansprüche 11 bis 14, **dadurch gekennzeichnet dass** ein Material der Lagerungsstruktur (B) im elastischen (Hookschen) Bereich arbeitet, der durch eine Federkonstante k definiert werden kann.

**Claims**

1. A device for detecting the contact with a display, comprising:

- a glass body (G),
- an electrode arrangement (E) comprising at least on electrode section,
- a bearing structure (B) for supporting the glass body (G) such that it experiences sufficient displacement as a result of a compressive force applied during contact with the glass body (G),
- a capacity sensor,
- wherein the at least one electrode section is coupled with the glass body (G) and the at least one electrode section forms part of a capacitive system whose capacity is changing by loading the bearing structure (B)
**characterized in that**
the at least one electrode section is applied directly to the lower side of the glass body (G), and the bearing structure (B) is arranged on a metal frame (R) arranged below the glass body such that each electrode section (E) in combination with the metal frame (R) and the bearing structure (B) forms a variable capacitor, which may be coupled with the capacity sensor and the capacity sensor is formed such that
- a change of capacity of the capacitive system is detected by means of a phase shift effect, and
- the electrode arrangement forms part of a LC network and the inductance thereof is formed by a gyrator circuit.

2. The device of claim 1, **characterized in that** the glass body (G) is formed as a rectangular pane and the at least one electrode section (E) is arranged in a corner area of the glass body (G).

3. The device of claim 2, **characterized in that** the at least one electrode section is implemented as a flat electrode.

4. The device of claim 3, **characterized in that** the flat electrode is implemented as a metallic layer.

5. The device of at least one of claims 1 to 4, **characterized in that** the glass body (G) comprises a glass screen.

6. The device of at least one of claims 1 to 5, **characterized in that** the capacity sensor comprises an operational amplifier operating as an impedance converter.

7. The device of claim 6, **characterized in that** the operational amplifier is configured such that a gain >1 exists.

8. The device of at least one of claims 1 to 7, wherein piezo sensors are provided for position detection of a finger on the glass body (G).

9. The device of at least one of claims 1 to 8, **characterized in that** the bearing structure (B) is formed by plastic springs.

10. The device of at least one of claims 1 to 8, **characterized in that** the bearing structure (B) comprises metal springs.

11. The device of at least one of claims 1 to 8, **characterized in that** the bearing structure (B) comprises a rubber profile.

12. The device of at least one of claims 1 to 8, **characterized in that** the bearing structure (B) comprises strips of foam plastic.

13. The device of at least one of claims 11 to 12, **char-**acterized in that** a material of the bearing structure (B) operates in an elastic (Hook's) range that can be defined by a spring constant k.

14. The device of at least one of claims 1 to 10, **characterized in that** the bearing structure (B) comprises strips of foam plastic.

15. The device of at least one of claims 11 to 14, **characterized in that** a material of the bearing structure (B) operates in an elastic (Hook's) range that can be defined by a spring constant k.

**Revendications**

1. Disposition pour la détection du contact d'un écran, avec :

    - un corps de vitre (G),
    - un dispositif à électrodes (E) qui comprend au moins une portion à électrode,
    - une structure de logement (B) pour le logement du corps de vitre (G), de façon à ce que celui-ci subisse, à la suite d'une force de pression exercée lors d'un contact du corps de vitre (G), un déplacement suffisant,
    - un capteur capacitif,
    - l'au moins une portion à électrode étant couplée avec le corps de vitre (G) et l'au moins une portion à électrode faisant partie d'un système capacitif dont la capacité change lors d'une sollicitation de la structure de logement (B),
    **caractérisé en ce que**
    - l'au moins une portion à électrode est appliquée en tant que structure conductrice directement sur un côté inférieur du corps de vitre (G) et la structure de logement (B) est disposée sur un cadre métallique (R) disposé sous le corps de vitre, de façon à ce que chaque portion à électrode (E) forme, en combinaison avec le cadre métallique (R) et la structure de logement (B), un condensateur variable, qui peut être couplé avec le capteur capacitif et le capteur capacitif est conçu de façon à ce que
    - une modification de la capacité du système capacitif soit détectée grâce à un effet de décalage de phase et
    - le dispositif à électrodes constitue une partie d'un réseau LC et l'inductance de celle-ci soit formée par un circuit girateur.

2. Disposition selon la revendication 1, **caractérisée en ce que** le corps de vitre (G) est conçu comme une vitre rectangulaire et **en ce que** l'au moins une portion à électrode (E) se trouve dans l'angle du corps de vitre (G).

3. Disposition selon la revendication 2, **caractérisée en ce que** l'au moins une portion à électrode est conçue comme une électrode plate.

4. Disposition selon la revendication 3, **caractérisée en ce que** l'électrode plate est conçue comme une couche métallique.

5. Disposition selon au moins l'une des revendications 1 à 4, **caractérisée en ce que** le corps de vitre (G) comprend une vitre en verre.

6. Disposition selon au moins l'une des revendications 1 à 5, **caractérisée en ce que** le capteur capacitif comprend un amplificateur opérationnel branché comme un convertisseur d'impédance.

7. Disposition selon la revendication 6, **caractérisée en ce que** l'amplificateur opérationnel est configuré de façon à obtenir une amplification > 1.

8. Disposition selon au moins l'une des revendications 1 à 7, **caractérisée en ce que**, pour la détection de la position d'un doigt sur le corps de vitre, des capteurs piézo-électriques sont prévus.

9. Disposition selon au moins l'une des revendications 1 à 8, **caractérisée en ce que** la structure de logement (B) est constituée de ressorts en matière plastique.

10. Disposition selon au moins l'une des revendications 1 à 8, **caractérisée en ce que** la structure de logement (B) comprend des ressorts métalliques.

11. Disposition selon au moins l'une des revendications 1 à 8, **caractérisée en ce que** la structure de logement (B) comprend un profilé en caoutchouc.

12. Disposition selon au moins l'une des revendications 1 à 8, **caractérisée en ce que** la structure de logement (B) comprend des bandes de matériau alvéolaire.

13. Disposition selon au moins l'une des revendications 11 à 12, **caractérisée en ce qu'**un matériau de la structure de logement (B) fonctionne dans le domaine élastique (de Hook), qui peut être défini par une constante élastique k.

14. Disposition selon au moins l'une des revendications 1 à 10, **caractérisée en ce que** la structure de logement (B) comprend des bandes de matériau alvéolaire.

15. Disposition selon au moins l'une des revendications 11 à 14, **caractérisée en ce qu'**un matériau de la structure de logement (B) fonctionne dans le domaine élastique (de Hook), qui peut être défini par une constante élastique k.

Fig. 1a

Fig. 1b

Fig. 2a

Fig. 2b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007022259 A
- EP 200601043 W

- DE 102006051184